# EUROPEAN PATENT SPECIFICATION

(11) **EP 2 832 539 B1**
(45) Date of publication and mention of the grant of the patent: **04.05.2016**
(21) Application number: 13768775.2
(22) Date of filing: 28.03.2013
(51) Int. Cl.: B32B 27/00, C08J 7/00, G02F 1/1333, H01L 31/042, H01L 51/50, H05B 33/02, H05B 33/14, B32B 7/12, B32B 27/08, B32B 27/28, B32B 7/02, H01L 51/44, H01L 51/52, H01L 31/048, H01L 31/049

(54) **GAS BARRIER FILM LAMINATE, MEMBER FOR ELECTRONIC DEVICE, AND ELECTRONIC DEVICE**
GASSPERRFILMLAMINAT, ELEMENT FÜR EINE ELEKTRONISCHE VORRICHTUNG UND ELEKTRONISCHE VORRICHTUNG
STRATIFIÉ À FILM BARRIÈRE AUX GAZ, ÉLÉMENT POUR DISPOSITIF ÉLECTRONIQUE ET DISPOSITIF ÉLECTRONIQUE

(30) Priority: 30.03.2012 JP 2012080222
(43) Date of publication of application: 04.02.2015
(73) Proprietor: Lintec Corporation, Tokyo 173-0001 (JP)
(72) Inventor: IWAYA Wataru, Tokyo 173-0001 (JP); NAGANAWA Satoshi, Tokyo 173-0001 (JP)
(74) Representative: Adam, Holger
(86) International application number: PCT/JP2013/059402
(87) International publication number: WO 2013/147093

(56) References cited:
- EP-A1- 1 732 362
- WO-A1-2010/005029
- WO-A1-2010/021326
- WO-A1-2010/107018
- WO-A1-2012/003416
- WO-A1-2012/039355
- JP-A- H06 190 997
- JP-A- 2007 150 084

## Description

### TECHNICAL FIELD

The invention relates to a gas barrier film laminate that exhibits an excellent gas barrier capability and excellent bendability, an electronic device member that includes the gas barrier film laminate, and an electronic device that includes the electronic device member.

### BACKGROUND ART

Use of a transparent plastic film as a substrate for an electronic member (e.g., solar cell, liquid crystal display, or electroluminescence (EL) display) instead of a glass sheet (plate) has been studied in order to implement a reduced thickness, a reduced weight, flexibility, impact resistance, and the like. However, a plastic film easily allows water vapor, oxygen, and the like to pass through as compared with a glass sheet, and may easily cause a deterioration in elements provided in the electronic member.

In order to solve the above problem, Patent Document 1 discloses a flexible display substrate in which a transparent gas barrier layer formed of a metal oxide is stacked on a transparent plastic film.

Patent Document 2 discloses a gas barrier laminate that includes a plastic film and a resin layer, the resin layer including a polyorganosilsesquioxane as the main component, and being stacked on at least one side of the plastic film.

Patent Document 3 discloses a transparent film in which a transparent gas barrier layer is formed on a first transparent plastic film base, and a second transparent plastic film base is provided on the transparent gas barrier layer through a transparent pressure-sensitive adhesive layer.

### RELATED-ART DOCUMENT

### PATENT DOCUMENT

Patent Document 1: JP-A-2000-338901
Patent Document 2: JP-A-2006-123307
Patent Document 3: JP-A-2006-327098

### SUMMARY OF THE INVENTION

### TECHNICAL PROBLEM

The applicant of the present application proposed a laminate that includes a gas barrier layer that is formed of a material that includes an oxygen atom, a carbon atom, and a silicon atom (see WO2010/021326 and WO2010/107018, for example). The laminates disclosed in these documents exhibit an excellent gas barrier capability.

The inventors of the present application conducted studies in order to obtain a laminate that exhibits a more excellent gas barrier capability, and developed a laminate in which at least two gas barrier films are stacked through a pressure-sensitive adhesive layer.

However, when the laminate in which the gas barrier films are bonded through the pressure-sensitive adhesive layer is bent, significant delamination (separation) and lifting may occur at the interface between the gas barrier film and the pressure-sensitive adhesive layer when the difference in thickness between the gas barrier films is large. It is considered that the above problem occurs due to concentration of bending stress at the interface between the gas barrier film and the pressure-sensitive adhesive layer when the difference in thickness between the gas barrier films is large.

The invention was conceived in view of the above situation. An object of the invention is to provide a gas barrier film laminate that exhibits an excellent gas barrier capability and excellent bendability (i.e., lifting rarely occurs when the gas barrier film laminate is bent), an electronic device member that includes the gas barrier film laminate, and an electronic device that includes the electronic device member.

### SOLUTION TO PROBLEM

The inventors conducted extensive studies in order to achieve the above object. As a result, the inventors found that a gas barrier film laminate that exhibits excellent bendability can be obtained by providing a bonding layer having a configuration in which a pressure-sensitive adhesive layer is contiguously stacked on each side of a base film formed of a synthetic resin having a tensile modulus at 23°C of 3000 to 10,000 MPa, instead of a pressure-sensitive adhesive layer through which gas barrier films are bonded.

Several aspects of the invention provide the following gas barrier film laminate (see (1) to (11)), electronic device member (see (12)), and electronic device (see (13)).
(1) A gas barrier film laminate including at least two gas barrier films and a bonding layer, the at least two gas barrier films being stacked through the bonding layer, the bonding layer having a configuration in which a pressure-sensitive adhesive layer is contiguously stacked on each side of a base film A, the base film A being formed of a synthetic resin having a tensile modulus at 23°C of 3000 to 10,000 MPa.
(2) The gas barrier film laminate according to (1), wherein the base film A has a thickness of 0.5 to 25 µm.
(3) The gas barrier film laminate according to (1), wherein the pressure-sensitive adhesive layer stacked on each side of the base film A has a thickness of 0.5 to 25 µm.
(4) The gas barrier film laminate according to (1), wherein the pressure-sensitive adhesive layer has a 180° peel adhesion with respect to the gas barrier film of 2.0 N/25 mm or more.
(5) The gas barrier film laminate according to (1), wherein the bonding layer has a thickness of 75 µm or less.
(6) The gas barrier film laminate according to (1), wherein the gas barrier film stacked on one side of the bonding layer has a thickness smaller than that of the gas barrier film stacked on the other side of the bonding layer.
(7) The gas barrier film laminate according to (1), wherein the ratio of the thickness of the gas barrier film stacked on one side of the bonding layer to the thickness of the gas barrier film stacked on the other side of the bonding layer (thickness of gas barrier film stacked on one side of bonding layer / thickness of gas barrier film stacked on the other side of bonding layer) is 0.05 to 1.0.
(8) The gas barrier film laminate according to (1), wherein at least one gas barrier film includes a base film B, and at least one gas barrier layer provided on the base film B.
(9) The gas barrier film laminate according to (8), wherein the gas barrier layer is a layer formed by implanting ions into a layer that includes a silicon-based polymer compound.
(10) The gas barrier film laminate according to (8), wherein the gas barrier film is stacked so that the gas barrier layer is contiguous to the bonding layer.
(11) The gas barrier film laminate according to (1), the gas barrier film laminate having a thickness of 100 µm or less.
(12) An electronic device member including the gas barrier film laminate according to (1).
(13) An electronic device including the electronic device member according to (12).

### ADVANTAGEOUS EFFECTS OF THE INVENTION

Since the gas barrier film laminate according to one aspect of the invention includes the bonding layer having the above properties, concentration of bending stress is reduced at the interface between the gas barrier film (having a larger thickness) and the bonding layer when the gas barrier film laminate is bent, and it is possible to solve a problem in which delamination (separation) and lifting occur at the interface between the gas barrier film (having a larger thickness) and the pressure-sensitive adhesive layer.

The gas barrier film laminate according to one aspect of the invention is suitable for an electronic member such as a solar cell, a liquid crystal display, and an electroluminescence (EL) display.

Since the electronic device member according to one aspect of the invention includes the gas barrier film laminate according to one aspect of the invention that exhibits an excellent gas barrier capability and excellent bendability, the electronic device member can suitably be used for an electronic device (e.g., touch panel, electronic paper, flexible display (e.g., organic/inorganic EL display), and solar cell).

### BRIEF DESCRIPTION OF DRAWINGS

FIG. 1 is a cross-sectional view illustrating examples of the layer configuration of a gas barrier film laminate according to one embodiment of the invention.
FIG. 2 is a cross-sectional view illustrating a process that produces a gas barrier film laminate according to one embodiment of the invention.

### DESCRIPTION OF EMBODIMENTS

A gas barrier film laminate, an electronic device member, and an electronic device according to several exemplary embodiments of the invention are described in detail in below.

### 1) Gas barrier film laminate

A gas barrier film laminate according to one embodiment of the invention includes at least two gas barrier films and a bonding layer, the at least two gas barrier films being stacked through the bonding layer, the bonding layer having a configuration in which a pressure-sensitive adhesive layer is contiguously stacked on each side of a base film, the base film A being formed of a synthetic resin having a tensile modulus at 23°C of 3000 to 10,000 MPa.

### Bonding layer

The bonding layer used in connection with one embodiment of the invention has a configuration in which the pressure-sensitive adhesive layer is contiguously stacked on each side of the base film (hereinafter referred to as "base film A"), the base film A being formed of a synthetic resin having a tensile modulus at 23°C of 3000 to 10,000 MPa.

The base film A is not particularly limited as long as the base film A is formed of a synthetic resin having a tensile modulus at 23°C of 3000 to 10,000 MPa, and can support the pressure-sensitive adhesive layer.

The synthetic resin that forms the base film A has a tensile modulus at 23°C of 3000 to 10,000 MPa, and preferably 3000 to 5000 MPa. If the tensile modulus is less than 3000 MPa, lifting may easily occur when the gas barrier film laminate is bent. If the tensile modulus exceeds 10,000 MPa, the bendability (flexibility) of the gas barrier film laminate may deteriorate.

Note that the tensile modulus at 23°C refers to a value measured in accordance with JIS K 7127.

Examples of the synthetic resin that forms the base film A include polyimides, polyamides, polyamideimides, polyphenylene ethers, polyether ketones, polyether ether ketones, polyolefins, polyesters, polycarbonates, polysulfones, polyether sulfones, polyphenylene sulfides, polyarylates, acrylic-based resins, cycloolefin-based polymers, aromatic polymers, and the like.

Among these, polyesters and cycloolefin-based polymers are preferable due to excellent transparency and versatility.

Examples of the polyesters include polyethylene terephthalate, polybuthylene terephthalate, polyethylene naphthalate, polyarylate, and the like.

Examples of the cycloolefin-based polymers include norbornene-based polymers, monocyclic olefin-based polymers, cyclic conjugated diene-based polymers, vinyl alicyclic hydrocarbon-based polymers, and hydrogenated products thereof.

The thickness of the base film A is normally 0.5 to 25 µm, preferably 1 to 10 µm, and more preferably 1 to 6 µm. When the thickness of the base film A is 0.5 µm or more, excellent workability is achieved when producing the gas barrier film laminate. When the thickness of the base film A is 25 µm or less, lifting rarely occurs when the gas barrier film laminate is bent.

The pressure-sensitive adhesive layer is contiguously stacked on each side of the base film A in order to hold the laminate structure. The pressure-sensitive adhesive layer is not particularly limited as long as the pressure-sensitive adhesive layer can prevent delamination (separation) of the gas barrier film and the base film A, and exhibits sufficient adhesion.

The two pressure-sensitive adhesive layers may be identical or different as to the type and the thickness.

The thickness of the pressure-sensitive adhesive layer is normally 0.5 to 25 µm, preferably 1 to 10 µm, and more preferably 1 to 6 µm. When the thickness of the pressure-sensitive adhesive layer is 0.5 µm or more, the pressure-sensitive adhesive layer exhibits sufficient adhesion, and lifting rarely occurs when the gas barrier film laminate is bent. When the thickness of the pressure-sensitive adhesive layer is 25 µm or less, it is advantageous from the viewpoint of productivity.

The pressure-sensitive adhesive layer preferably has a 180° peel adhesion with respect to the gas barrier film of 2.0 N/25 mm or more. When the 180° peel adhesion is 2.0 N/25 mm or more, the pressure-sensitive adhesive layer exhibits sufficient adhesion to the gas barrier film, and lifting rarely occurs when the gas barrier film laminate is bent.

Note that the term "180° peel adhesion with respect to the gas barrier film" used herein in connection with the pressure-sensitive adhesive layer refers to the 180° peel adhesion of an adhesion test pressure-sensitive adhesive film (prepared by lining one side of the pressure-sensitive adhesive layer with a polyester film) with respect to the gas barrier film measured in accordance with JIS Z 0237 (2000) (see the examples).

The type of the pressure-sensitive adhesive is not particularly limited. A known pressure-sensitive adhesive such as an acrylic-based pressure-sensitive adhesive, a rubber-based pressure-sensitive adhesive, a polyester-based pressure-sensitive adhesive, a urethane-based pressure-sensitive adhesive, or a silicone-based pressure-sensitive adhesive, may be used as the pressure-sensitive adhesive. It is preferable to use an acrylic-based pressure-sensitive adhesive since excellent adhesion can be obtained.

The acrylic-based pressure-sensitive adhesive is a pressure-sensitive adhesive that includes an acrylic-based copolymer as the main component.

The acrylic-based copolymer is a copolymer that includes a repeating unit derived from (meth)acrylic acid or a (meth)acrylate. Note that the term "(meth)acrylic acid" used herein refers to acrylic acid and methacrylic acid, and the term "(meth)acrylate" used herein refers to an acrylate and a methacrylate.

The acrylic-based copolymer may include a repeating unit other than the repeating unit derived from (meth)acrylic acid or a (meth)acrylate as long as the advantageous effects of the invention are not impaired.

It is preferable that the acrylic-based copolymer include a repeating unit that includes a functional group that can form a crosslinked structure (e.g., carboxyl group, hydroxyl group, amino group, or amide group), and a repeating unit that does not include the functional group.

Examples of the monomers used to produce the acrylic-based copolymer include an acrylic-based monomer that includes the functional group, an acrylic-based monomer that does not include the functional group, and an additional monomer that is copolymerizable with these monomers.

Examples of the acrylic-based monomer that includes the functional group include an acrylic-based monomer that includes a carboxyl group, such as (meth)acrylic acid and 2-carboxyethyl (meth)acrylate; an acrylic-based monomer that includes a hydroxyl group, such as 2-hydroxyethyl (meth)acrylate, 2-hydroxypropyl (meth)acrylate, 3-hydroxypropyl (meth)acrylate, 2-hydroxybutyl (meth)acrylate, 3-hydroxybutyl (meth)acrylate, and 4-hydroxybutyl (meth)acrylate; and the like.

Among these, an acrylic-based monomer that includes a carboxyl group, such as (meth)acrylic acid and 2-carboxyethyl (meth)acrylate is preferable, and (meth)acrylic acid is more preferable.

These monomers may be used either alone or in combination.

Examples of the acrylic-based monomer that does not include the functional group include an acrylic-based monomer that includes a linear alkyl group, such as methyl (meth)acrylate, ethyl (meth)acrylate, propyl (meth)acrylate, butyl (meth)acrylate, pentyl (meth)acrylate, hexyl (meth)acrylate, octyl (meth)acrylate, decyl (meth)acrylate, dodecyl (meth)acrylate, myristyl (meth)acrylate, palmityl (meth)acrylate, and stearyl (meth)acrylate; an acrylic-based monomer that includes a branched alkyl group, such as 2-ethylhexyl (meth)acrylate and isooctyl (meth)acrylate; an acrylic-based monomer that includes a cycloalkyl group, such as cyclohexyl (meth)acrylate; and the like.

Among these, a monomer that includes a hydrocarbon group having 4 to 10 carbon atoms is preferable, and butyl (meth)acrylate is more preferable, since a pressure-sensitive adhesive layer that exhibits excellent adhesion can be formed.

These monomers may be used either alone or in combination.

Examples of the additional monomer include a monomer that includes a carboxyl group, such as crotonic acid, maleic acid, fumaric acid, itaconic acid, and citraconic acid; a monomer that includes an amide group, such as (meth)acrylamide, N-methyl(meth)acrylamide, and N-methylol(meth)acrylamide; acrylonitrile; styrene; vinyl acetate; vinylpyrrolidone; and the like.

An initiator used for polymerization is not particularly limited. Examples of the initiator include peroxide-based initiators such as benzoyl peroxide, lauroyl peroxide, and methyl ethyl ketone peroxide, azo-based initiators such as azobisisobutyronitrile, azobiscyanovarelic acid, and azobiscyanopentane, and the like.

A solvent used for polymerization is not particularly limited. Examples of the solvent include toluene, hexane, heptane, ethyl acetate, acetone, methyl ethyl ketone, methanol, and the like.

Known polymerization conditions (e.g., polymerization temperature and polymerization time) may be employed.

A crosslinking agent may be added to the acrylic-based pressure-sensitive adhesive. The crosslinking agent is a compound that reacts with the functional group to effect crosslinking. The crosslinking agent is not particularly limited. Examples of the crosslinking agent include an isocyanate-based crosslinking agent, an epoxy-based crosslinking agent, and the like. It is preferable to use the isocyanate-based crosslinking agent.

The isocyanate-based crosslinking agent is not particularly limited. A compound that includes two or more isocyanate groups in the molecule may be used as the isocyanate-based crosslinking agent. Examples of the isocyanate-based crosslinking agent include aromatic polyisocyanates such as tolylene diisocyanate, diphenylmethane diisocyanate, and xylylene diisocyanate; aliphatic polyisocyanates such as hexamethylenediisocyanate; alicyclic polyisocyanates such as isophorone diisocyanate and hydrogenated diphenylmethane diisocyanate; biuret compounds, isocyanurate compounds, and adducts (i.e., reaction products with a low-molecular-weight active hydrogen-containing compound (e.g., ethylene glycol, propylene glycol, neopentyl glycol, trimethylolpropane, or castor oil)) thereof; and the like.

A compound that includes two or more epoxy groups in the molecule is used as the epoxy-based crosslinking agent. Examples of the epoxy-based crosslinking agent include sorbitol tetraglycidyl ether, trimethylolpropane triglycidyl ether, tetraglycidyl-1,3-bisaminomethylcyclohexane, tetraglycidyl-m-xylenediamine, triglycidyl-p-aminophenol, and the like.

These crosslinking agents may be used either alone or in combination.

The crosslinking agent is normally used in an amount of 0.01 to 10 parts by mass, and preferably 0.05 to 5 parts by mass, based on 100 parts by mass of the acrylic-based copolymer.

The acrylic-based pressure-sensitive adhesive is preferably used as a solvent-based pressure-sensitive adhesive. The solvent is not particularly limited. A known solvent may be used.

The weight average molecular weight of the acrylic-based copolymer is normally 100,000 to 2,000,000, and preferably 300,000 to 900,000.

The weight average molecular weight of the acrylic-based copolymer can be adjusted by adjusting the amount of initiator, or adding a chain transfer agent.

Note that the weight average molecular weight of the acrylic-based copolymer refers to a polystyrene-reduced weight average molecular weight determined by gel permeation chromatography (GPC).

These acrylic-based copolymers may be used either alone or in combination when preparing the acrylic-based pressure-sensitive adhesive.

The acrylic-based copolymer may be produced using an arbitrary method. A known method such as a solution polymerization method, an emulsion polymerization method, a suspension polymerization method, or a bulk polymerization method may be used. It is preferable to use a solution polymerization method due to ease of polymerization.

The pressure-sensitive adhesive may include a known additive such as a tackifier, a filler, a pigment, or a UV absorber. It is preferable that the pressure-sensitive adhesive include a tackifier so that a pressure-sensitive adhesive layer that exhibits sufficient adhesion can be formed, and a gas barrier film laminate that exhibits excellent bendability can be obtained. Examples of the tackifier include natural resins such as a rosin-based resin and a polyterpene-based resin, petroleum resins such as a C5-based resin, a C9-based resin, and a dicyclopentadiene-based resin, synthetic resins such as a coumarone-indene resin and a xylene resin, and the like.

The pressure-sensitive adhesive layer may be formed using an arbitrary method. The pressure-sensitive adhesive layer may be formed using a known method. For example, the pressure-sensitive adhesive component may be dissolved in an organic solvent (e.g., toluene, ethyl acetate, or methyl ethyl ketone) to prepare a pressure-sensitive adhesive layer-forming composition. The pressure-sensitive adhesive layer-forming composition may be applied to a release film (release sheet) using a known coating method (e.g., spin coating method, spray coating method, bar coating method, knife coating method, roll coating method, blade coating method, die coating method, or gravure coating method), and the solvent may be removed from the resulting film by drying, followed by optional heating to form a pressure-sensitive adhesive layer. In this case, a pressure-sensitive adhesive layer provided with a release film is obtained. The pressure-sensitive adhesive layer may also be formed by applying the pressure-sensitive adhesive layer-forming composition directly to the base film A, and drying the resulting film. It is preferable to use the former method since the bonding layer can be efficiently produced.

A known release sheet may be used as the release sheet. Examples of the release sheet include a resin film such as a polyethylene terephthalate film and a polypropylene film; a sheet obtained by subjecting the surface of such a resin film to a release treatment using a silicone-based release agent; and the like.

The bonding layer has a configuration in which the pressure-sensitive adhesive layer is contiguously stacked on each side of the base film A. The thickness of the bonding layer is normally 75 µm or less, preferably 1.5 to 20 µm, and more preferably 2.0 to 15 µm. When the thickness of the bonding layer is 75 µm or less, it is possible to obtain a gas barrier film laminate that has a reduced thickness, and exhibits excellent bendability.

The bonding layer may be obtained by bonding a pressure-sensitive adhesive layer provided with a release film to one side of the base film A so that the surface of the one side of the base film A faces the pressure-sensitive adhesive layer, and bonding another pressure-sensitive adhesive layer provided with a release film to the other side of the base film A so that the surface of the other side of the base film A faces the pressure-sensitive adhesive layer, for example. In this case, a bonding layer provided with a release film is obtained. The bonding layer may also be obtained by applying the pressure-sensitive adhesive layer-forming composition directly to one side of the base film A, drying the resulting film to form a pressure-sensitive adhesive layer on one side of the base film A, applying the pressure-sensitive adhesive layer-forming composition directly to the other side of the base film A, and drying the resulting film to form a pressure-sensitive adhesive layer on the other side of the base film A. It is preferable to use the former method since the bonding layer can be efficiently produced.

### Gas barrier film

The gas barrier film used in connection with one embodiment of the invention is a film that exhibits a capability to suppress transmission (penetration) of oxygen and water vapor (hereinafter may be referred to as "gas barrier capability").

The water vapor transmission rate of the gas barrier film at a temperature of 40°C and a relative humidity of 90% is preferably 1.0 g/m²/day or less, and more preferably 0.5 g/m²/day or less. A gas barrier laminate that exhibits an excellent gas barrier capability can be obtained by utilizing the gas barrier film having a modulus of water vapor transmission rate within the above range.

The thickness of the gas barrier film used in connection with one embodiment of the invention is normally 0.5 to 100 µm, preferably 1 to 50 µm, and more preferably 5 to 30 µm.

The at least two gas barrier films included in the gas barrier film laminate according to one embodiment of the invention may have an identical thickness. Note that bendability is significantly improved when the gas barrier film stacked on one side of the bonding layer has a thickness smaller than that of the gas barrier film stacked on the other side of the bonding layer.

It is preferable that the ratio of the thickness of the gas barrier film stacked on one side of the bonding layer (i.e., the gas barrier film having a smaller thickness) to the thickness of the gas barrier film stacked on the other side of the bonding layer (i.e., the gas barrier film having a larger thickness) be 0.05 to 1.0, more preferably 0.1 to 0.5, and still more preferably 0.2 to 0.3.

Examples of the gas barrier film include a single-layer film formed of a synthetic resin, and a laminate film obtained by forming a gas barrier layer on a base film formed of a synthetic resin (hereinafter may be referred to as "base film B") either directly or through an additional layer.

Examples of the synthetic resin that forms the single-layer film include one synthetic resin or two or more synthetic resins selected from polyvinyl alcohol, polyethylene terephthalate, very-low-density polyethylene, polyvinyl chloride, polyvinylidene chloride, a fluororesin, a polyamide-based resin, an ethylene-vinyl alcohol copolymer, polyphenylene sulfide, polyacrylonitrile, and the like.

It is preferable that at least one gas barrier film include the base film B, and at least one gas barrier layer provided on the base film B, since an excellent gas barrier capability can be obtained.

Examples of the material for forming the base film B include those mentioned above in connection with the base film A.

It is preferable to use a polyester, a polyamide, or a cycloolefin polymer due to excellent transparency and versatility. It is more preferable to use a polyester or a cycloolefin polymer.

Examples of the polyester include polyethylene terephthalate, polybuthylene terephthalate, polyethylene naphthalate, polyarylate, and the like.

Examples of the polyamide include wholly aromatic polyamides, nylon 6, nylon 66, nylon copolymers, and the like.

Examples of the cycloolefin-based polymer include norbornene-based polymers, monocyclic olefin-based polymers, cyclic conjugated diene-based polymers, vinyl alicyclic hydrocarbon-based polymers, and hydrogenated products thereof.

The thickness of the base film B is normally 0.5 to 80 µm, preferably 1 to 40 µm, and more preferably 1 to 30 µm.

The gas barrier layer included in the gas barrier film is a layer that exhibits a gas barrier capability.

The gas barrier layer may be formed on only one side of the base film B, or may be formed on each side of the base film B. The gas barrier layer may be a single layer, or may be a layer in which a plurality of layers are stacked.

A material for forming the gas barrier layer is not particularly limited as long as the material suppresses transmission of oxygen and water vapor. It is preferable that the material for forming the gas barrier layer exhibit excellent transparency and an excellent gas barrier capability.

Examples of the material for forming the gas barrier layer include metals such as aluminum, magnesium, zinc, and tin; inorganic oxides such as silicon oxide, aluminum oxide, magnesium oxide, zinc oxide, indium oxide, and tin oxide; inorganic nitrides such as silicon nitride; inorganic carbides; inorganic sulfides; inorganic oxynitrides; inorganic oxycarbides; inorganic carbonitrides; inorganic oxycarbonitrides; polymer compounds; and the like.

The gas barrier layer may be formed using an arbitrary method. For example, the gas barrier layer may be formed using a method that forms a layer of the above material on the base film B using a deposition (evaporation) method, a sputtering method, an ion plating method, a thermal CVD method, a plasma CVD method, or the like, a method that applies a solution prepared by dissolving or dispersing the above material in an organic solvent to the base film B using a known coating method, and appropriately dries the resulting film, or a method that subjects a polymer layer formed of a polymer compound to a plasma treatment or an ion implantation treatment.

The thickness of the gas barrier layer is not particularly limited, but is normally 20 nm to 50 µm, preferably 30 nm to 1 µm, and more preferably 40 to 500 nm.

It is preferable to form the gas barrier layer by subjecting a polymer layer formed of a polymer compound to an ion implantation treatment since the desired gas barrier layer can be easily formed. The polymer layer formed of the polymer compound is modified by the ion implantation treatment, and exhibits an improved gas barrier capability.

The ion implantation treatment may be implemented using a known method. It is preferable to form the gas barrier layer by implanting ions into the polymer layer formed of the polymer compound. An excellent gas barrier capability can be obtained by forming the gas barrier layer as described above.

In this case, the term "gas barrier layer" does not refer to only the part modified by ion implantation, but refers to the polymer layer that includes the part modified by ion implantation.

Examples of the polymer compound that forms the polymer layer include silicon-based polymer compounds, polyimides, polyamides, polyamideimides, polyphenylene ethers, polyether ketones, polyether ether ketones, polyolefins, polyesters, polycarbonates, polysulfones, polyether sulfones, polyphenylene sulfides, polyallylates, acrylic-based resins, cycloolefin-based polymers, aromatic polymers, combinations of two or more polymers among these polymers, and the like.

Among these, silicon-based polymer compounds, polyesters, and acrylic-based resins are preferable, and silicon-based polymer compounds are more preferable, since a gas barrier layer that exhibits an excellent gas barrier capability can be easily formed.

The silicon-based polymer compound may be either an organic compound or an inorganic compound as long as the silicon-based polymer compound is a polymer that includes silicon. Examples of the silicon-based polymer compound include a polyorganosiloxane-based compound, a polycarbosilane-based compound, a polysilane-based compound, a polysilazane-based compound, and the like.

The polyorganosiloxane-based compound is a compound obtained by polycondensing a silane compound that includes a hydrolyzable functional group.

The main chain structure of the polyorganosiloxane-based compound is not particularly limited. The main chain structure of the polyorganosiloxane-based compound may be linear, ladder-like, or polyhedral.

Examples of the linear main chain structure of the polyorganosiloxane-based compound include a structure represented by the following formula (a). Examples of the ladder-like main chain structure of the polyorganosiloxane-based compound include a structure represented by the following formula (b). Examples of the polyhedral main chain structure of the polyorganosiloxane-based compound include a structure represented by the following formula (c). 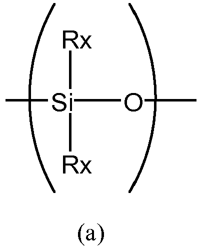 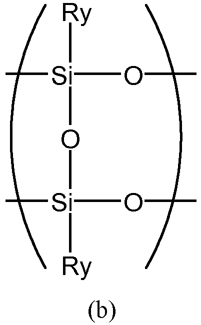 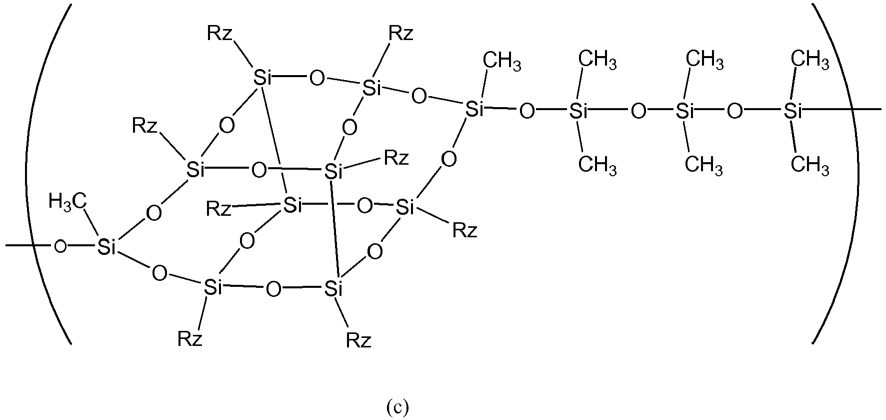 wherein Rx, Ry, and Rz are independently a hydrogen atom or a non-hydrolyzable group such as a substituted or unsubstituted alkyl group, a substituted or unsubstituted alkenyl group, or a substituted or unsubstituted aryl group. Note that a plurality of Rx in the formula (a), a plurality of Ry in the formula (b), and a plurality of Rz in the formula (c) may respectively be either identical or different, provided that a case where both Rx in the formula (a) are a hydrogen atom is excluded.

Examples of the unsubstituted alkyl group include alkyl groups having 1 to 10 carbon atoms (e.g., methyl group, ethyl group, n-propyl group, isopropyl group, n-butyl group, isobutyl group, sec-butyl group, t-butyl group, n-pentyl group, isopentyl group, neopentyl group, n-hexyl group, n-heptyl group, and n-octyl group).

Examples of the alkenyl group include alkenyl groups having 2 to 10 carbon atoms (e.g., vinyl group, 1-propenyl group, 2-propenyl group, 1-butenyl group, 2-butenyl group, and 3-butenyl group).

Examples of a substituent that may substitute the alkyl group and a substituent that may substitute the alkenyl group include halogen atoms such as a fluorine atom, a chlorine atom, a bromine atom, and an iodine atom; a hydroxyl group; a thiol group; an epoxy group; a glycidoxy group; a (meth)acryloyloxy group; substituted or unsubstituted aryl groups such as a phenyl group, a 4-methylphenyl group, and a 4-chlorophenyl group; and the like.

Examples of the unsubstituted aryl group include aryl groups having 6 to 10 carbon atoms (e.g., phenyl group, 1-naphthyl group, and 2-naphthyl group).

Examples of a substituent that may substitute the aryl group include halogen atoms such as a fluorine atom, a chlorine atom, a bromine atom, and an iodine atom; alkyl groups having 1 to 6 carbon atoms, such as a methyl group and an ethyl group; alkoxy groups having 1 to 6 carbon atoms, such as a methoxy group and an ethoxy group; a nitro group; a cyano group; a hydroxyl group; a thiol group; an epoxy group; a glycidoxy group; a (meth)acryloyloxy group; substituted or unsubstituted aryl groups such as a phenyl group, a 4-methylphenyl group, and a 4-chlorophenyl group; and the like.

Rx, Ry, and Rz are preferably a hydrogen atom, an alkyl group having 1 to 6 carbon atoms, or a phenyl group, and particularly preferably an alkyl group having 1 to 6 carbon atoms.

The polyorganosiloxane-based compound is preferably a linear compound represented by the formula (a), and more preferably a polydimethylsiloxane represented by the formula (a) in which both Rx are a methyl group, from the viewpoint of availability and a capability to form a layer that exhibits an excellent gas barrier capability.

The polyorganosiloxane-based compound may be produced using a known production method that polycondenses a silane compound that includes a hydrolyzable functional group, for example.

The term "polycarbosilane-based compound" used herein refers to a polymer compound that includes an -Si-C- bond in the main chain of the molecule. A compound that includes a repeating unit represented by the following formula (d) is preferable as the polycarbosilane-based compound. 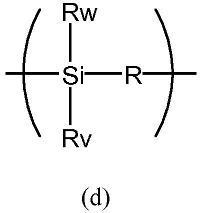 wherein Rw and Rv are independently a hydrogen atom, a hydroxyl group, an alkyl group, an aryl group, an alkenyl group, or a monovalent heterocyclic group, provided that a plurality of Rw and a plurality of Rv are respectively either identical or different.

Examples of the alkyl group, the aryl group, and the alkenyl group represented by Rw and Rv include those mentioned above in connection with Rx and the like.

These groups may be substituted with a substituent (e.g., alkyl group, aryl group, alkoxy group, or aryloxy group) at an arbitrary position.

R is an alkylene group, an arylene group, or a divalent heterocyclic group.

Examples of the alkylene group represented by R include alkylene groups having 1 to 10 carbon atoms, such as a methylene group, an ethylene group, a propylene group, a trimethylene group, a tetramethylene group, a pentamethylene group, a hexamethylene group, and an octamethylene group.

Examples of the arylene group include arylene groups having 6 to 20 carbon atoms, such as a phenylene group, a 1,4-naphthylene group, and a 2,5-naphthylene group.

The divalent heterocyclic group is not particularly limited as long as the divalent heterocyclic group is a divalent group derived from a 3 to 10-membered cyclic compound that includes a carbon atom and at least one heteroatom (e.g., oxygen atom, nitrogen atom, or sulfur atom).

The alkylene group, the arylene group, and the divalent heterocyclic group represented by R may be substituted with a substituent (e.g., alkyl group, aryl group, alkoxy group, or halogen atom) at an arbitrary position.

It is preferable to use a polycarbosilane-based compound that includes the repeating unit represented by the formula (d) in which Rw and Rv are independently a hydrogen atom, an alkyl group, or an aryl group, and R is an alkylene group or an arylene group. It is more preferable to use a polycarbosilane-based compound that includes the repeating unit represented by the formula (d) in which Rw and Rv are independently a hydrogen atom or an alkyl group, and R is an alkylene group.

The weight average molecular weight of the polycarbosilane-based compound that includes the repeating unit represented by the formula (d) is normally 400 to 12,000.

The polycarbosilane-based compound may be produced using an arbitrary known method.

The term "polysilane-based compound" used herein refers to a polymer compound that includes an -Si-Si- bond in the molecule. Examples of the polysilane-based compound include a compound that includes at least one repeating unit selected from structural units represented by the following formula (e). 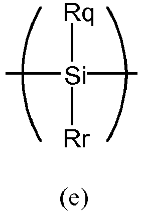 wherein Rq and Rr are independently a hydrogen atom, an alkenyl group, a cycloalkyl group, a cycloalkenyl group, an aryl group, a hydroxyl group, an alkoxy group, a cycloalkyloxy group, an aryloxy group, an aralkyloxy group, a substituted or unsubstituted amino group, a silyl group, or a halogen atom.

Examples of the alkyl group, the alkenyl group, and the aryl group represented by Rq and Rr include those mentioned above in connection with Rx and the like.

Examples of the cycloalkyl group include cycloalkyl groups having 3 to 10 carbon atoms, such as a cyclopentyl group, a cyclohexyl group, and a methylcyclohexyl group.

Examples of the cycloalkenyl group include cycloalkenyl groups having 4 to 10 carbon atoms, such as a cyclopentenyl group and a cyclohexenyl group.

Examples of the alkoxy group include alkoxy groups having 1 to 10 carbon atoms, such as a methoxy group, an ethoxy group, a propoxy group, an isopropoxy group, a butoxy group, a t-butoxy group, and a pentyloxy group.

Examples of the cycloalkyloxy group include cycloalkyloxy groups having 3 to 10 carbon atoms, such as a cyclopenthyloxy group and a cyclohexyloxy group.

Examples of the aryloxy group include aryloxy groups having 6 to 20 carbon atoms, such as a phenoxy group and a naphthyloxy group.

Examples of the aralkyloxy group include aralkyloxy groups having 7 to 20 carbon atoms, such as a benzyloxy group, a phenethyloxy group, and a phenylpropyloxy group.

Examples of the substituted or unsubstituted amino group include an amino group; N-monosubstituted or N,N-disubstituted amino groups substituted with an alkyl group, a cycloalkyl group, an aryl group, an aralkyl group, an acyl group, or the like; and the like.

Examples of the silyl group include Si₁₋₁₀ silanyl groups (preferably Si₁₋₆ silanyl groups) such as a silyl group, a disilanyl group, and a trisilanyl group, substituted silyl groups (e.g., a substituted silyl group substituted with an alkyl group, a cycloalkyl group, an aryl group, an aralkyl group, an alkoxy group, or the like), and the like.

Examples of the halogen atom include a fluorine atom, a chlorine atom, a bromine atom, an iodine atom, and the like.

The cycloalkyl group, the cycloalkenyl group, the alkoxy group, the cycloalkyloxy group, the aryloxy group, the aralkyloxy group, and the silyl group may be substituted with a substituent (e.g., halogen atom, alkyl group, aryl group, or alkoxy group).

It is preferable to use a polysilane-based compound that includes the repeating unit represented by the formula (e), more preferably a polysilane-based compound that includes the repeating unit represented by the formula (e) in which Rq and Rr are independently a hydrogen atom, a hydroxyl group, an alkyl group, an aryl group, an alkoxy group, an amino group, or a silyl group, and still more preferably a polysilane-based compound that includes the repeating unit represented by the formula (e) in which Rq and Rr are independently a hydrogen atom, an alkyl group, or an aryl group, since the advantageous effects of the invention can be more easily obtained.

The configuration of the polysilane-based compound is not particularly limited. The polysilane-based compound may be a homopolymer (e.g., noncyclic polysilane (e.g., linear polysilane, branched polysilane, or network polysilane) or cyclic polysilane), or may be a copolymer (e.g., random copolymer, block copolymer, alternating copolymer, or comb-like copolymer).

When the polysilane-based compound is a noncyclic polysilane, the end group (terminal substituent) of the polysilane-based compound may be a hydrogen atom, a halogen atom (e.g., chlorine atom), an alkyl group, a hydroxyl group, an alkoxy group, a silyl group, or the like.

Specific examples of the polysilane-based compound include homopolymers such as a polydialkylsilane such as polydimethylsilane, poly(methylpropylsilane), poly(methylbutylsilane), poly(methylpentylsilane), poly(dibutylsilane), and poly(dihexylsilane), a polydiarylsilane such as poly(diphenylsilane), and a poly(alkylarylsilane) such as poly(methylphenylsilane); copolymers such as a copolymer of a dialkylsilane and another dialkylsilane (e.g., dimethylsilane-methylhexylsilane copolymer), an arylsilane-alkylarylsilane copolymer (e.g., phenylsilane-methylphenylsilane copolymer), and a dialkylsilane-alkylarylsilane copolymer (e.g., dimethylsilane-methylphenylsilane copolymer, dimethylsilane-phenylhexylsilane copolymer, dimethylsilane-methylnaphthylsilane copolymer, and methylpropylsilane-methylphenylsilane copolymer); and the like.

The average degree of polymerization (e.g., number average degree of polymerization) of the polysilane-based compound is normally about 5 to about 400, preferably about 10 to about 350, and more preferably about 20 to about 300.

The weight average molecular weight of the polysilane-based compound is about 300 to about 100,000, preferably about 400 to about 50,000, and more preferably about 500 to about 30,000.

A number of polysilane-based compounds are known in the art. Such polysilane-based compounds may be produced using a known method.

The term "polysilazane-based compound" used herein refers to a polymer compound that includes an -Si-N- bond in the molecule. The polysilazane-based compound is preferably a compound that includes a repeating unit represented by the following formula (f).

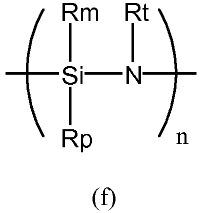

The number average molecular weight of the polysilazane-based compound is not particularly limited, but is preferably 100 to 50,000.

In the formula (f), n is an arbitrary natural number.

Rm, Rp, and Rt are independently a non-hydrolyzable group (e.g., hydrogen atom, alkyl group, cycloalkyl group, alkenyl group, aryl group, or alkylsilyl group).

Examples of the alkyl group, the alkenyl group, and the aryl group include those mentioned above in connection with Rx and the like.

Examples of the cycloalkyl group include those mentioned above in connection with Rq and the like.

Examples of the alkylsilyl group include a trimethylsilyl group, a triethylsilyl group, a triisopropylsilyl group, a tri-t-butylsilyl group, a methyldiethylsilyl group, a dimethylsilyl group, a diethylsilyl group, a methylsilyl group, an ethylsilyl group, and the like.

Among these, a hydrogen atom, an alkyl group having 1 to 6 carbon atoms, or a phenyl group is preferable as Rm, Rp, and Rt. A hydrogen atom is particularly preferable as Rm, Rp, and Rt.

The polysilazane-based compound that includes the repeating unit represented by the formula (f) may be an inorganic polysilazane in which each of Rm, Rp, and Rt is a hydrogen atom, or an organic polysilazane in which at least one of Rm, Rp, and Rt is not a hydrogen atom.

Examples of the inorganic polysilazane include a perhydropolysilazane that has a linear structure that includes a repeating unit represented by the following formula, has a molecular weight of 690 to 2000, and includes three to ten SiH₃ groups in one molecule (see JP-B-63-16325), 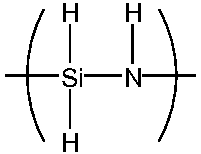 a perhydropolysilazane that has a linear structure and a branched structure, and includes a repeating unit represented by the following formula (A), 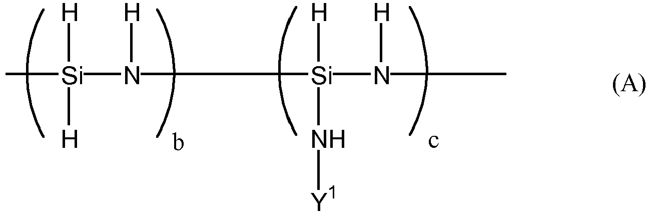 wherein b and c are an arbitrary natural number, and Y¹ is a hydrogen atom or a group represented by the following formula (B), 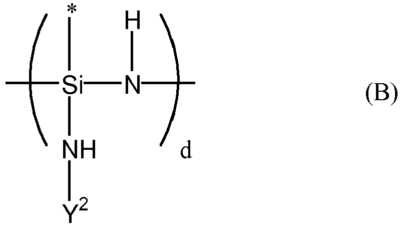 wherein d is an arbitrary natural number, * is a bonding position, and Y² is a hydrogen atom or a group represented by the formula (B), a perhydropolysilazane that has a linear structure, a branched structure, and a cyclic structure in its molecule, and includes the perhydropolysilazane structure represented by the following formula (C), 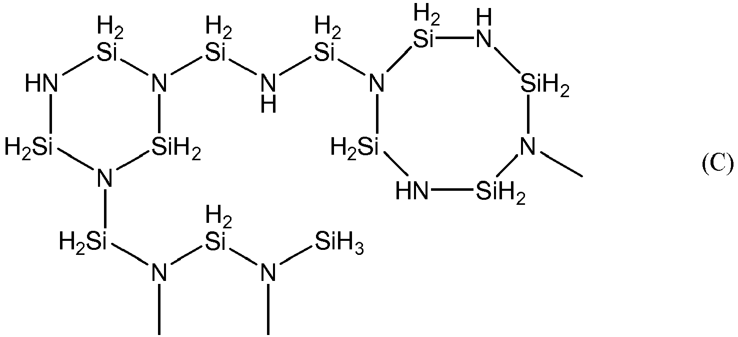 and the like.

Examples of the organic polysilazane include:
(i) a polysilazane that includes a repeating unit represented by -(Rm'SiHNH)- (wherein Rm' is an alkyl group, a cycloalkyl group, an alkenyl group, an aryl group, or an alkylsilyl group similar to those represented by Rm (hereinafter the same)), and has a cyclic structure having a degree of polymerization of 3 to 5;
(ii) a polysilazane that includes a repeating unit represented by -(Rm'SiHNRt')-(wherein Rt' is an alkyl group, a cycloalkyl group, an alkenyl group, an aryl group, or an alkylsilyl group similar to those represented by Rt), and has a cyclic structure having a degree of polymerization of 3 to 5;
(iii) a polysilazane that includes a repeating unit represented by -(Rm'Rp'SiNH)-(wherein Rp' is an alkyl group, a cycloalkyl group, an alkenyl group, an aryl group, or an alkylsilyl group similar to those represented by Rp), and has a cyclic structure having a degree of polymerization of 3 to 5;
(iv) a polyorgano(hydro)silazane that includes a structure represented by the following formula in the molecule; 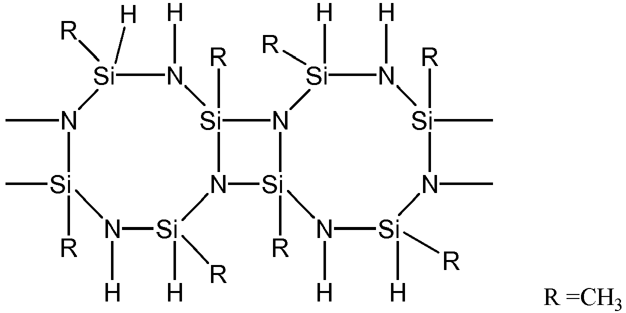
(v) a polysilazane that includes a repeating unit represented by the following formula, 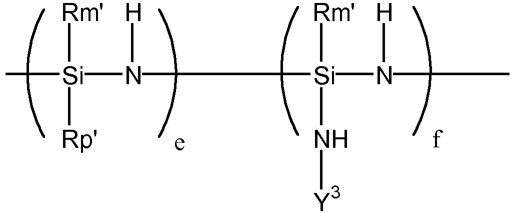 wherein Rm' and Rp' are the same as defined above, e and f are arbitrary natural numbers, and Y³ is a hydrogen atom or a group represented by the following formula (D), 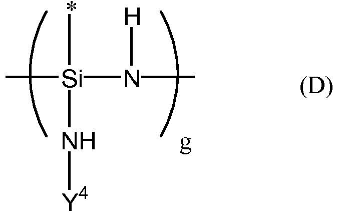 wherein g is an arbitrary natural number, * is a bonding position, and Y⁴ is a hydrogen atom or the group represented by the formula (D); and the like.

The above organic polysilazanes may be produced using a known method. For example, the above organic polysilazanes may be produced by reacting ammonia or a primary amine with a reaction product of a secondary amine and a substituted or unsubstituted halogenosilane compound represented by the following formula.

R¹₄₋ₘSiXₘ

wherein m is 2 or 3, X is a halogen atom, and R¹ is a substituent that substitutes Rm, Rp, Rt, Rm', Rp', or Rt'.

The secondary amine, ammonia, and the primary amine may be appropriately selected corresponding to the structure of the desired polysilazane-based compound.

A modified polysilazane may be used as the polysilazane-based compound. Examples of the modified polysilazane include a polymetallosilazane that includes a metal atom (which may be crosslinked), a polysiloxazane that includes a repeating unit represented by (SiH₂)ⱼ(NH)ₕ) and a repeating unit represented by (SiH₂)ᵢO (wherein j, h, and i are independently 1, 2, or 3) (see JP-A62-195024), a polyborosilazane produced by reacting a polysilazane with a boron compound (see JP-A-2-84437), a polymetallosilazane produced by reacting a polysilazane with a metal alkoxide (see JP-A-63-81122, for example), an inorganic silazane polymer and a modified polysilazane (see JP-A-1-138108, for example), a copolymer silazane produced by introducing an organic component into a polysilazane (see JP-A-2-175726, for example), a low-temperature ceramic polysilazane obtained by adding a ceramic-forming catalyst compound to a polysilazane (see JP-A-5-238827, for example), a silicon alkoxide-addition polysilazane (see JP-A-5-238827), a glycidol-addition polysilazane (see JP-A-6-122852), an acetylacetonato complex-addition polysilazane (see JP-A-6-306329), a metal carboxylate-addition polysilazane (see JP-A-6-299118, for example), a polysilazane composition produced by adding an amine and/or acid to the above polysilazane or modified polysilazane (see JP-A-9-31333), a modified polysilazane produced by adding an alcohol (e.g., methanol) or hexamethyldisilazane to the terminal nitrogen (N) atom of perhydropolysilazane (see JP-A-5-345826 and JP-A-4-63833), and the like.

The polysilazane-based compound used in connection with one embodiment of the invention is preferably an inorganic polysilazane in which each of Rm, Rp, and Rt is a hydrogen atom, or an organic polysilazane in which at least one of Rm, Rp, and Rt is not a hydrogen atom, and more preferably an inorganic polysilazane from the viewpoint of availability and a capability to form an implanted layer that exhibits an excellent gas barrier capability.

A product commercially available as a glass coating material or the like may be used directly as the polysilazane-based compound.

The polymer layer that forms the gas barrier layer may include an additional component other than the polymer compound as long as the object of the invention is not impaired. Examples of the additional component include a curing agent, an additional polymer, an aging preventive, a light stabilizer, a flame retardant, and the like.

The content of the polymer compound in the polymer layer is preferably 50 mass% or more, and more preferably 70 mass% or more, from the viewpoint of forming a gas barrier layer that exhibits an excellent gas barrier capability.

The polymer layer may be formed using an arbitrary method. For example, the polymer layer may be formed by applying a layer-forming solution that includes at least one polymer compound, an optional additional component, a solvent, and the like to the base or a primer layer optionally formed on the base using a known coating method, and appropriately drying the resulting film.

A spin coater, a knife coater, a gravure coater, or the like may be used to apply the layer-forming solution.

It is preferable to heat the resulting film in order to dry the film, and improve the gas barrier capability of the film. The film may be heated and dried using a known drying method such as hot-air drying, heat roll drying, or infrared irradiation. The heating temperature is normally 80 to 150°C, and the heating time is normally several tens of seconds to several tens of minutes.

The thickness of the polymer layer is not particularly limited, but is normally 20 to 1000 nm, preferably 30 to 500 nm, and more preferably 40 to 200 nm.

According to one embodiment of the invention, a film that exhibits a sufficient gas barrier capability can be obtained by implanting ions as described below, even when the polymer layer has a thickness at a nanometer level.

The dose of ions implanted into the polymer layer may be appropriately determined taking account of the intended use of the resulting film (e.g., desired gas barrier capability and transparency), and the like.

Examples of the ions implanted into the polymer layer include ions of rare gases such as argon, helium, neon, krypton, and xenon; ions of fluorocarbons, hydrogen, nitrogen, oxygen, carbon dioxide, chlorine, fluorine, and sulfur; ions of alkane gases such as methane, ethane, propane, butane, pentane, and hexane; ions of alkene gases such as ethylene, propylene, butene, and pentene; ions of alkadiene gases such as pentadiene and butadiene; ions of alkyne gases such as acetylene and methylacetylene; ions of aromatic hydrocarbon gases such as benzene, toluene, xylene, indene, naphthalene, and phenanthrene; ions of cycloalkane gases such as cyclopropane and cyclohexane; ions of cycloalkene gases such as cyclopentene and cyclohexene; ions of conductive metals such as gold, silver, copper, platinum, nickel, palladium, chromium, titanium, molybdenum, niobium, tantalum, tungsten, and aluminum; ions of silane (SiH₄) or organosilicon compounds such as tetramethoxysilane, dimethyldimethoxysilane, diphenyldimethoxysilane, and hexamethyldisiloxane; and the like.

These ions may be used either alone or in combination.

It is preferable to use ions of at least one element selected from the group consisting of hydrogen, nitrogen, oxygen, argon, helium, neon, xenon, and krypton from the viewpoint of ease of implantation and a capability to form a gas barrier layer that exhibits a particularly excellent gas barrier capability.

The ions may be implanted using an arbitrary method. For example, the ions may be implanted by applying ions (ion beams) accelerated by an electric field, implanting ions present in plasma (plasma ion implantation method), or the like. It is preferable to use the plasma ion implantation method since a gas barrier film can be easily obtained.

It is preferable to use a plasma ion implantation method (A) that implants ions present in plasma generated by utilizing an external electric field into the surface area of the polymer layer, or a plasma ion implantation method (B) that implants ions present in plasma generated due to an electric field produced by applying a negative high-voltage pulse to the polymer layer into the surface area of the polymer layer.

When using the plasma ion implantation method (A), it is preferable to set the ion implantation pressure (plasma ion implantation pressure) to 0.01 to 1 Pa. When the ion implantation pressure is within the above range, ions can be easily, efficiently, and uniformly implanted, and the desired gas barrier layer can be efficiently formed.

The plasma ion implantation method (B) has advantages in that it is unnecessary to increase the degree of decompression, the operation is simple, and the processing time can be significantly reduced. Moreover, the entire polymer layer can be uniformly processed, and ions present in the plasma can be continuously implanted into the surface area of the polymer layer with high energy by applying a negative high-voltage pulse. The method (B) also has an advantage in that an excellent ion-implanted layer can be uniformly formed in the surface area of the polymer layer by merely applying a negative high-voltage pulse to the polymer layer without requiring a special means such as a high-frequency power supply (e.g., radio frequency (RF) power supply or microwave power supply).

When using the plasma ion implantation method (A) or (B), the pulse width when applying a negative high-voltage pulse (i.e., during ion implantation) is preferably 1 to 15 µsec. When the pulse width is within the above range, ions can be easily, efficiently, and uniformly implanted.

The voltage applied when generating plasma is preferably -1 to -50 kV, more preferably -1 to -30 kV, and particularly preferably -5 to -20 kV. If the applied voltage is higher than -1 kV, the ion implantation dose may be insufficient, and the desired performance may not be obtained. If the applied voltage is lower than -50 kV, the film may be charged during ion implantation, or coloration of the film may occur, for example.

Examples of the ion species used for plasma ion implantation include those mentioned above.

A plasma ion implantation apparatus is used when implanting ions present in plasma into the surface area of the polymer layer. Specific examples of the plasma ion implantation apparatus include (α) a plasma ion implantation apparatus that causes the polymer layer (hereinafter may be referred to as "ion implantation target layer") to be evenly enclosed by plasma by superimposing high-frequency electric power on a feed-through that applies a negative high-voltage pulse to the ion implantation target layer so that ions present in the plasma are attracted to and collide with the target, and thereby implanted and deposited therein (JP-A-2001-26887), (β) a plasma ion implantation apparatus that includes an antenna in a chamber, wherein high-frequency electric power is applied to generate plasma, and positive and negative pulses are alternately applied to the ion implantation target layer after the plasma has reached an area around the ion implantation target layer, so that ions present in the plasma are attracted to and implanted into the target while heating the ion implantation target layer, causing electrons present in the plasma to be attracted to and collide with the target due to the positive pulse, and applying the negative pulse while controlling the temperature by controlling the pulse factor (JP-A-2001-156013), (γ) a plasma ion implantation apparatus that generates plasma using an external electric field utilizing a high-frequency electric power supply such as a microwave power supply, and causes ions present in the plasma to be attracted to and implanted into the target by applying a high-voltage pulse, (δ) a plasma ion implantation apparatus that implants ions present in plasma generated due to an electric field produced by applying a high-voltage pulse without using an external electric field, and the like.

It is preferable to use the plasma ion implantation apparatus (γ) or (δ) since the plasma ion implantation apparatus (γ) or (δ) allows a simple operation, significantly reduces the treatment time, and can be continuously used.

Examples of a method that utilizes the plasma ion implantation apparatus (γ) or (δ) include the method disclosed in WO2010/021326.

Since the plasma ion implantation apparatus (γ) or (δ) is configured so that the high-voltage pulse power supply is used as a plasma generation means that generates plasma, plasma can be generated, and ions present in the plasma can be continuously implanted into the surface area of the polymer layer by merely applying a negative high-voltage pulse to the polymer layer without requiring a special means such as a high-frequency power supply (e.g., RF power supply or microwave power supply), and a gas barrier film in which a polymer layer having a surface area modified by ion implantation (i.e., gas barrier layer) is formed can be mass-produced.

The thickness of the ion implantation target area can be controlled by adjusting the implantation conditions (e.g., type of ions, applied voltage, and implantation time), and may be determined taking account of the thickness of the polymer layer, the intended use of the gas barrier film, and the like. The thickness of the ion implantation target area is normally 10 to 1000 nm.

Whether or not ions have been implanted may be determined by performing elemental analysis on the surface area of the polymer layer up to a depth of about 10 nm using X-ray photoelectron spectroscopy (XPS).

### Gas barrier film laminate

The gas barrier film laminate according to one embodiment of the invention has a configuration in which at least two gas barrier films are stacked through the bonding layer.

The shape of the gas barrier film laminate according to one embodiment of the invention is not particularly limited. For example, the gas barrier film laminate may be in the shape of a sheet or the like.

The number of gas barrier films included (stacked) in the gas barrier film laminate according to one embodiment of the invention is not particularly limited as long as the number of gas barrier films is 2 or more. The number of gas barrier films included (stacked) in the gas barrier film laminate is normally 2 to 5.

The gas barrier film and the bonding layer may be bonded using an arbitrary method. For example, the gas barrier film and the bonding layer may be bonded using a known method utilizing a laminator or the like.

The layer configuration of the gas barrier film laminate according to one embodiment of the invention is not particularly limited as long as at least two gas barrier films are stacked through the bonding layer.

The thickness of the gas barrier film laminate according to one embodiment of the invention is normally 100 µm or less, and preferably 1 to 50 µm. When the thickness of the gas barrier film laminate is 100 µm or less, the weight of an electronic member that utilizes the gas barrier film laminate can be reduced, for example.

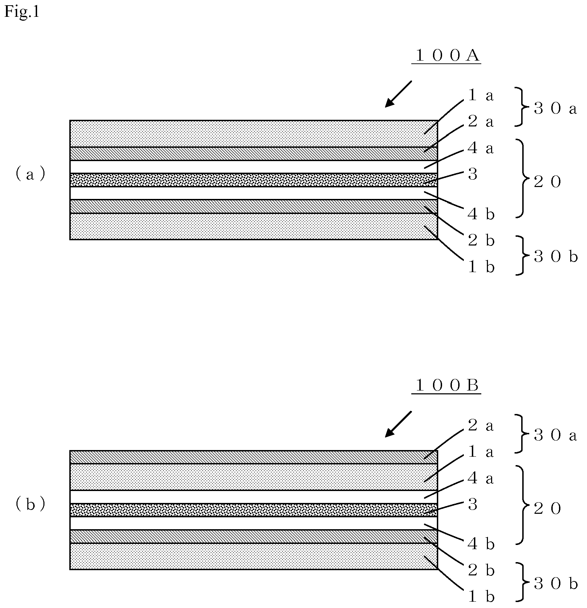

FIG. 1 illustrates examples of the gas barrier film laminate according to one embodiment of the invention.

A gas barrier film laminate 100A illustrated in FIG. 1 (see (a)) has a layer configuration (base film B1a/gas barrier layer 2a/pressure-sensitive adhesive layer 4a/base film A 3/pressure-sensitive adhesive layer 4b/gas barrier layer 2b/base film B 1b) in which two gas barrier films 30a and 30b are stacked so that a gas barrier layer 2a and a gas barrier layer 2b are contiguous to a bonding layer 20 (i.e., the gas barrier layer 2a and the gas barrier layer 2b are respectively contiguous to a pressure-sensitive adhesive layer 4a and a pressure-sensitive adhesive layer 4b of the bonding layer 20).

A gas barrier film laminate 100B illustrated in FIG. 1 (see (b)) has a layer configuration (gas barrier layer 2a/base film B 1a/pressure-sensitive adhesive layer 4a/base film A 3/pressure-sensitive adhesive layer 4b/gas barrier layer 2b/base film B 1b) in which the gas barrier films 30a and 30b are stacked so that the base layer 1a of the gas barrier film 30a is contiguous to the bonding layer 20 (i.e., the base layer 1a of the gas barrier film 30a is contiguous to the pressure-sensitive adhesive layer 4a of the bonding layer 20), and the gas barrier layer 2b of the gas barrier film 30b is contiguous to the bonding layer 20 (i.e., the gas barrier layer 2b of the gas barrier film 30b is contiguous to the pressure-sensitive adhesive layer 4b of the bonding layer 20).

It is preferable that the gas barrier films be stacked so that the gas barrier layer of at least one gas barrier film is contiguous to the bonding layer (see (a) and (b) in FIG. 1). It is more preferable that the gas barrier films be stacked so that the gas barrier layer of each gas barrier film is contiguous to the bonding layer (see (a) in FIG. 1).

When the gas barrier layer is contiguous to the bonding layer, the gas barrier layer is rarely damaged. Therefore, a gas barrier film laminate that rarely shows a deterioration in water vapor barrier capability can be obtained.

The at least two gas barrier films may be stacked through the bonding layer using an arbitrary method. The at least two gas barrier films may be stacked through the bonding layer using a known method.

For example, the gas barrier film laminate 100A having the layer configuration (base film B 1a/gas barrier layer 2a/pressure-sensitive adhesive layer 4a/base film A 3/pressure-sensitive adhesive layer 4b/gas barrier layer 2b/base film B 1b) illustrated in FIG. 1 (see (a)) may be produced as described below.

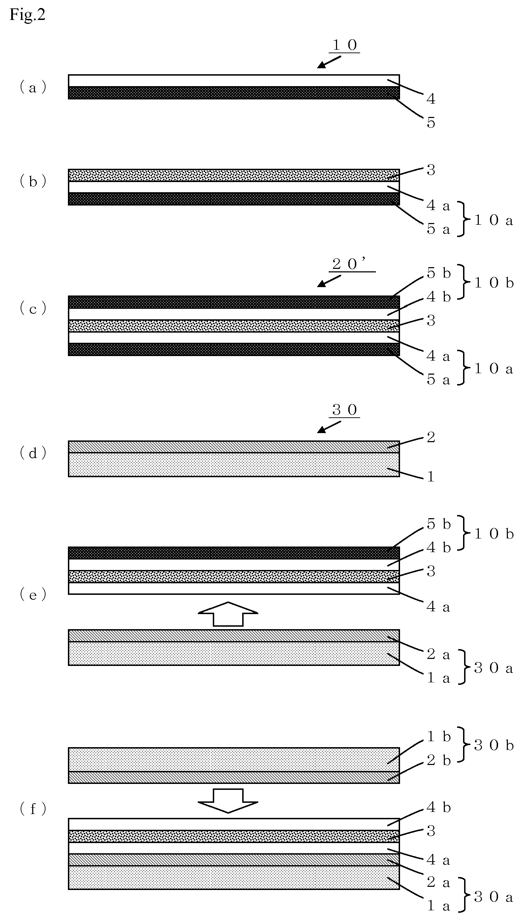

Specifically, a pressure-sensitive adhesive layer 4 is formed on a release film 5 to obtain a release film 10 provided with a pressure-sensitive adhesive layer (10a, 10b) (see (a) in FIG. 2).

The pressure-sensitive adhesive layer 4a of the release film 10a is bonded to the base film A 3 (see (b) in FIG. 2), and the pressure-sensitive adhesive layer 4b of the release film 10b is bonded to the base film A 3 (see (c) in FIG. 2) to obtain a laminate 20' for forming a bonding layer. The pressure-sensitive adhesive layer may be bonded to the base film using an arbitrary method. For example, the pressure-sensitive adhesive layer may be bonded to the base film using a known laminator.

Two gas barrier film 30 (30a, 30b) that respectively include a base film B 1 and a gas barrier layer 2 provided on the base film are provided (see (d) in FIG. 2).

After removing the release film 5a from the laminate 20' obtained as described above, the gas barrier layer 2a of the gas barrier film 30a is bonded to the exposed pressure-sensitive adhesive layer 4a (see (e) in FIG. 2). After removing the release film 5b from the laminate 20', the gas barrier layer 2b of the gas barrier film 30b is bonded to the exposed pressure-sensitive adhesive layer 4b (see (f) in FIG. 2) to obtain the gas barrier film laminate 100A.

The gas barrier film laminate according to one embodiment of the invention may optionally include an additional layer such as a protective layer, a conductive layer, or a primer layer. The additional layer may be situated at an arbitrary position. The additional layer may be a single layer, or may include a plurality of identical or different layers.

### Protective layer

The protective layer is required to exhibit excellent transparency and excellent scratch resistance. The protective layer protects the gas barrier film laminate when an impact is externally applied to the gas barrier film laminate.

The protective layer may be situated at an arbitrary position. It is preferable that the protective layer be situated as the outermost layer of the gas barrier film laminate.

A material for forming the protective layer is not particularly limited. The protective layer may be formed using an arbitrary known material. Examples of the material for forming the protective layer include silicon-containing compounds; polymerizable compositions that include a photopolymerizable compound that includes a photopolymerizable monomer and/or a photopolymerizable prepolymer, and an initiator that generates radicals at least due to light in the visible region; resins such as a polyester-based resin, a polyurethane-based resin (particularly a two-component curable resin that includes an isocyanate compound and a polyacrylic polyol, a polyester polyol, a polyether polyol, or the like), an acrylic-based resin, a polycarbonate-based resin, a vinyl chloride/vinyl acetate copolymer, a polyvinyl butyral-based resin, and a nitrocellulose-based resin; alkyl titanates; ethyleneimine; and the like. These materials may be used either alone or in combination.

The protective layer may be formed by dissolving or dispersing the above material in an appropriate solvent to prepare a protective layer-forming solution, applying the protective layer-forming solution to the target layer (i.e., a layer on which the protective layer to be formed) using a known method to form a film, drying the film, and optionally heating the dried film.

The protective layer-forming solution may be applied using a normal wet coating method. Examples of the wet coating method include a dipping method, a roll coating method, a gravure coating method, a knife coating method, an air knife coating method, a roll knife coating method, a die coating method, a screen printing method, a spray coating method, a gravure offset method, and the like.

The film formed by applying the protective layer-forming solution may be dried using a known drying method such as hot-air drying, heat roll drying, or infrared irradiation. The thickness of the protective layer may be appropriately selected taking account of the intended use of the gas barrier film laminate. The thickness of the protective layer is preferably 0.05 to 50 µm, more preferably 0.1 to 10 µm, and still more preferably 0.2 to 5 µm.

If the thickness of the protective layer is less than 0.05 µm, the protective layer may exhibit insufficient scratch resistance. If the thickness of the protective layer exceeds 50 µm, curling may easily occur due to strain during curing.

### Conductive layer

Examples of a material for forming the conductive layer include metals, alloys, metal oxides, electrically conductive compounds, mixtures thereof, and the like. Specific examples of the material for forming the conductive layer include antimony-doped tin oxide (ATO); fluorine-doped tin oxide (FTO); conductive metal oxides such as tin oxide, zinc oxide, indium oxide, indium tin oxide (ITO), and indium zinc oxide (IZO); metals such as gold, silver, chromium, and nickel; mixtures of these metals and conductive metal oxides; inorganic conductive materials such as copper iodide and copper sulfide; organic conductive materials such as polyaniline, polythiophene, and polypyrrole; and the like.

It is preferable to use a conductive metal oxide (particularly preferably ITO) as the material for forming the conductive layer from the viewpoint of transparency. The conductive layer may be a laminate in which a plurality of layers formed of these materials are stacked.

The conductive layer may be formed using a deposition (evaporation) method, a sputtering method, an ion plating method, a thermal CVD method, a plasma CVD method, or the like. It is preferable to form the conductive layer using a sputtering method since the conductive layer can be easily formed.

When forming the conductive layer using a sputtering method, a discharge gas (e.g., argon) is introduced into a vacuum chamber. A high-frequency voltage or a direct-current voltage is applied between a target and a substrate to generate plasma, and the plasma is allowed to collide with the target so that the target material is scattered and adheres to the substrate to obtain a thin film. The target is formed using the material for forming the conductive layer.

The thickness of the conductive layer is appropriately selected taking account of the application and the like. The thickness of the conductive layer is normally 10 nm to 50 µm, and preferably 20 nm to 20 µm. The surface resistivity of the conductive layer is normally 1000 Ω/sq. or less.

The conductive layer may optionally be patterned. The conductive layer may be patterned by chemical etching (e.g., photolithography), physical etching using a laser or the like, a vacuum deposition method using a mask, a sputtering method using a mask, a lift-off method, a printing method, or the like.

### Primer layer

The primer layer improves the interlayer adhesion between the base film B and the gas barrier layer (or another layer). The interlayer adhesion and the surface flatness can be improved by providing the primer layer.

A material for forming the primer layer is not particularly limited. The primer layer may be formed using an arbitrary known material. Examples of the material for forming the primer layer include silicon-containing compounds; polymerizable compositions that include a photopolymerizable compound that includes a photopolymerizable monomer and/or a photopolymerizable prepolymer, and an initiator that generates radicals at least due to light in the visible region; resins such as a polyester resin, a polyurethane resin (particularly a two-component curable resin that includes an isocyanate compound and a polyacryl polyol, a polyester polyol, a polyether polyol, or the like), an acrylic resin, a polycarbonate resin, a vinyl chloride/vinyl acetate copolymer, a polyvinyl butyral resin, and a nitrocellulose resin; alkyl titanates; ethyleneimine; and the like. These materials may be used either alone or in combination.

The primer layer may be formed by dissolving or dispersing the material for forming the primer layer in an appropriate solvent to prepare a primer layer-forming solution, applying the primer layer-forming solution to one side or each side of the base film B (or another layer), drying the resulting film, and optionally heating the dried film.

The primer layer-forming solution may be applied to the base film B (or another layer) using a normal wet coating method. Examples of the wet coating method include a dipping method, a roll coating method, a gravure coating method, a knife coating method, an air knife coating method, a roll knife coating method, a die coating method, a screen printing method, a spray coating method, a gravure offset method, and the like.

The film formed by applying the primer layer-forming solution may be dried using a known drying method such as hot-air drying, heat-roll drying, or infrared irradiation. The thickness of the primer layer is normally 10 to 1000 nm, and preferably 20 to 4000 nm.

Since the gas barrier film laminate according to one embodiment of the invention includes the bonding layer having the above properties, concentration of bending stress is reduced at the interface between the gas barrier film (having a larger thickness) and the bonding layer when the gas barrier film laminate is bent, and it is possible to solve a problem in which delamination (separation) and lifting occur at the interface between the gas barrier film (having a larger thickness) and the pressure-sensitive adhesive layer.

### 2) Electronic device member and electronic device

An electronic device member according to one embodiment of the invention includes the gas barrier film laminate according to one embodiment of the invention. Therefore, the electronic device member according to one embodiment of the invention exhibits an excellent gas barrier capability, and prevents a deterioration in an element due to gas (e.g., water vapor). Since the electronic device member exhibits excellent light transmittance and heat resistance, the electronic device member may suitably be used as a display member for touch panels, liquid crystal displays, EL displays, and the like; a solar cell back side protective sheet; and the like.

An electronic device according to one embodiment of the invention includes the electronic device member according to one embodiment of the invention. Specific examples of the electronic device include a touch panel, a liquid crystal display, an organic EL display, an inorganic EL display, electronic paper, a solar cell, and the like.

### EXAMPLES

The invention is further described below by way of examples. Note that the invention is not limited to the following examples.

### (1) Preparation of pressure-sensitive adhesive composition

100 parts by mass of an acrylic-based copolymer produced using butyl acrylate (BA) and acrylic acid (AA) (mass ratio (BA:AA)=90:10, weight average molecular weight: 550,000) and 0.22 parts by mass of an isocyanate-based crosslinking agent ("BHS-8515" manufactured by Toyo Ink Mfg. Co., Ltd., concentration: 37.5 mass%) were mixed. The mixture was diluted with methyl ethyl ketone to prepare a pressure-sensitive adhesive composition A having a nonvolatile content of 30 mass%.

### (2) Production of gas barrier film

A polysilazane compound (a coating material including perhydropolysilazane as the main component ("Aquamika NL110-20" manufactured by Clariant Japan K.K.)) was spin-coated onto a polyethylene terephthalate film (PET film) ("PET25T-100" manufactured by Mitsubishi Plastics Inc., thickness: 25 µm) (base film B), and heated at 120°C for 1 minute to form a polysilazane layer including perhydropolysilazane and having a thickness of 150 nm on the PET film.

Argon (Ar) ions were implanted into the surface of the polysilazane layer under the following conditions using a plasma ion implantation apparatus to form a gas barrier layer to produce a gas barrier film A.

The details of the plasma ion implantation apparatus and the ion implantation conditions used to form the gas barrier layer are shown below.

Plasma ion implantation apparatus
RF power supply: "RF56000" manufactured by JEOL Ltd.
High-voltage pulse power supply: "PV-3-HSHV-0835" manufactured by Kurita
Seisakusho Co., Ltd.
Plasma ion implantation conditions
Plasma-generating gas: Ar
Gas flow rate: 100 sccm
Duty ratio: 0.5%
Applied voltage: -6 kV
RF power supply: frequency: 13.56 MHz, applied electric power: 1000 W
Chamber internal pressure: 0.2 Pa
Pulse width: 5 µsec
Treatment time (ion implantation time): 200 seconds

A gas barrier film B was produced in the same manner as described above, except that a polyethylene terephthalate film (PET film) ("Diafoil K205-6E" manufactured by Mitsubishi Plastics Inc., thickness: 6 µm) was used as the base film B.

The ratio of the thickness of the gas barrier film B to the thickness of the gas barrier film A (thickness of gas barrier film B / thickness of gas barrier film A) was 0.24.

### (3) Tensile modulus of base film A included in bonding layer

Resin films used as the base film A included in the bonding layer, and the tensile modulus of the resin films are shown below.
Resin film 1: PET film ("Diafoil K100-2.0W" manufactured by Mitsubishi Plastics Inc., thickness: 2 µm, tensile modulus at 23°C: 3300 MPa)
Resin film 2: cycloolefin-based resin film ("ARTON" manufactured by JSR Corporation, thickness: 5 µm, tensile modulus at 23°C: 4300 MPa)
Resin film 3: polysulfone-based resin film ("ULTRASON S3030" manufactured by BASF, thickness: 2 µm, tensile modulus at 23°C: 2400 MPa)
Resin film 4: polysulfone-based resin film ("ULTRASON S3030" manufactured by BASF, thickness: 5 µm, tensile modulus at 23°C: 2400 MPa)

Note that the tensile modulus at 23°C was measured using a tensile tester ("TENSILON RTA-100" manufactured by Orientec Co., Ltd.) in accordance with JIS K 7127.

### Example 1

The pressure-sensitive adhesive composition A was applied to the surface of a release layer of a release film in which a silicone release layer was provided on one side of a PET film having a thickness of 38 µm ("SP-PET381031" manufactured by Lintec Corporation) using a comma direct coating method, and the resulting film was dried at 100°C for 1 minute to obtain a release film A provided with a pressure-sensitive adhesive layer having a thickness of 2 µm.

The pressure-sensitive adhesive layer of one release film A was bonded to the resin film 1, and the pressure-sensitive adhesive layer of another release film A was bonded to the resin film 1 to obtain a laminate A for forming a bonding layer.

After removing one of the release films from the laminate A, the exposed pressure-sensitive adhesive layer was bonded to the gas barrier layer of the gas barrier film A. After removing the other release film from the laminate A, the exposed pressure-sensitive adhesive layer was bonded to the gas barrier layer of the gas barrier film B to produce a gas barrier film laminate A.

### Example 2

A gas barrier film laminate B was produced in the same manner as in Example 1, except that the resin film 2 was used as the base film of the bonding layer instead of the resin film 1.

### Comparative Example 1

The pressure-sensitive adhesive composition A was applied to the surface of a release layer of the above release film ("SP-PET381031" manufactured by Lintec Corporation) using a comma direct coating method, and the resulting film was dried at 100°C for 1 minute to obtain a release film B provided with a pressure-sensitive adhesive layer having a thickness of 6 µm.

The gas barrier layer of the gas barrier film A was bonded to the pressure-sensitive adhesive layer of the release film B, and the release film was removed.

The exposed pressure-sensitive adhesive layer was bonded to the gas barrier layer of the gas barrier film B to produce a gas barrier film laminate C that did not include the base film A.

### Comparative Example 2

A gas barrier film laminate D that did not include the base film A was produced in the same manner as in Comparative Example 1, except that a release film C provided with a pressure-sensitive adhesive layer having a thickness of 10 µm was used instead of the release film B.

### Comparative Example 3

A gas barrier film laminate E was produced in the same manner as in Example 1, except that the resin film 3 was used as the base film of the bonding layer instead of the resin film 1.

### Comparative Example 4

A gas barrier film laminate F was produced in the same manner as in Example 1, except that the resin film 4 was used as the base film of the bonding layer instead of the resin film 1.

### Adhesion test

A polyethylene terephthalate (PET) film ("PET25T-100" manufactured by Mitsubishi Plastics, Inc., thickness: 25 µm) was bonded to the pressure-sensitive adhesive layer of each of the release films A to C used in the examples and comparative examples. The resulting laminate was cut to a width of 25 mm and a length of 250 mm to obtain a pressure-sensitive adhesive test film.

After removing the release film from the pressure-sensitive adhesive test film, the exposed pressure-sensitive adhesive layer was bonded to the gas barrier layer of the gas barrier film A, and a roll having a weight of 2 kg was reciprocated once on the laminate to obtain a specimen. When 24 hours had elapsed, adhesion (N/25 mm) at a tensile speed of 300 mm/min and a peeling angle of 180° was measured in accordance with JIS Z 0237.

The measurement results are shown in Table 1.

### Bendability test

Each of the gas barrier film laminates A to F obtained in Examples 1 and 2 and Comparative Examples 1 to 4 was bent at the center so that the gas barrier film A was positioned on the outer side, and passed between two rolls of a laminator ("LAMIPACKER LPC1502" manufactured by Fujipla, Inc.) at a laminating speed of 5 m/min and a temperature of 23°C under a pressure of 0.18 MPa. The gas barrier film laminate was then observed with the naked eye. The gas barrier film laminate was evaluated in accordance with the following standard.
Good: No lifting was observed in the gas barrier film laminate.
Poor: Lifting was observed in the gas barrier film laminate.

The evaluation results are shown in Table 1.

**TABLE 1**

| | | Example | | Comparative Example | | | |
|---|---|---|---|---|---|---|---|
| | | 1 | 2 | 1 | 2 | 3 | 4 |
| Bonding layer | Thickness (µm) of pressure-sensitive adhesive layer | 2 | 2 | 6 | 10 | 2 | 2 |
| | Base film A | 1 | 2 | - | - | 3 | 4 |
| | Thickness (µm) of bonding layer | 6 | 9 | 6 | 10 | 6 | 9 |
| Gas barrier film laminate | | A | B | C | D | E | F |
| Adhesion test (N/25 mm) | | 3 | 3 | 8 | 9 | 3 | 3 |
| Bendability test | | Good | Good | Poor | Poor | Poor | Poor |

The following were confirmed from the results shown in Table 1.

The gas barrier film laminates A and B obtained in Examples 1 and 2 exhibited excellent bendability.

When only the pressure-sensitive adhesive layer was used as the bonding layer (Comparative Examples 1 and 2), the gas barrier film laminate exhibited poor bendability irrespective of the thickness of the pressure-sensitive adhesive layer.

When the base film formed of the synthetic resin having a tensile modulus at 23°C of less than 3000 MPa was used (Comparative Examples 3 and 4), the gas barrier film laminate exhibited poor bendability.

### REFERENCE SIGNS LIST

- 1, 1a, 1b:: Base film B
- 2, 2a, 2b:: Gas barrier layer
- 3:: Base film A
- 4, 4a, 4b:: Pressure-sensitive adhesive layer
- 5, 5a, 5b:: Release film
- 10, 10a, 10b:: Release film provided with pressure-sensitive adhesive layer
- 20:: Bonding layer
- 20':: Laminate for forming bonding layer
- 30, 30a, 30b:: Gas barrier film
- 100A, 100B:: Gas barrier film laminate

## Claims

1. A gas barrier film laminate comprising at least two gas barrier films and a bonding layer, the at least two gas barrier films being stacked through the bonding layer,
the bonding layer having a configuration in which a pressure-sensitive adhesive layer is contiguously stacked on each side of a base film A, the base film A being formed of a synthetic resin having a tensile modulus at 23°C of 3000 to 10,000 MPa, measured at 23 °C in accordance with JIS K 7127.

2. The gas barrier film laminate according to claim 1, wherein the base film A has a thickness of 0.5 to 25 µm.

3. The gas barrier film laminate according to claim 1, wherein the pressure-sensitive adhesive layer stacked on each side of the base film A has a thickness of 0.5 to 25 µm.

4. The gas barrier film laminate according to claim 1, wherein the pressure-sensitive adhesive layer has a 180° peel adhesion with respect to the gas barrier film, measured in accordance with JIS Z 0237 (2000), of 2.0 N/25 mm or more.

5. The gas barrier film laminate according to claim 1, wherein the bonding layer has a thickness of 75 µm or less.

6. The gas barrier film laminate according to claim 1, wherein the gas barrier film stacked on one side of the bonding layer has a thickness smaller than that of the gas barrier film stacked on the other side of the bonding layer.

7. The gas barrier film laminate according to claim 1, wherein the ratio of the thickness of the gas barrier film stacked on one side of the bonding layer to the thickness of the gas barrier film stacked on the other side of the bonding layer (thickness of gas barrier film stacked on one side of bonding layer / thickness of gas barrier film stacked on the other side of bonding layer) is 0.05 to 1.0.

8. The gas barrier film laminate according to claim 1, wherein at least one gas barrier film includes a base film B, and at least one gas barrier layer provided on the base film B.

9. The gas barrier film laminate according to claim 8, wherein the gas barrier layer is a layer formed by implanting ions into a layer that includes a silicon-based polymer compound.

10. The gas barrier film laminate according to claim 8, wherein the gas barrier film is stacked so that the gas barrier layer is contiguous to the bonding layer.

11. The gas barrier film laminate according to claim 1, the gas barrier film laminate having a thickness of 100 µm or less.

12. An electronic device member comprising the gas barrier film laminate according to claim 1.

13. An electronic device comprising the electronic device member according to claim 12.

## Patentansprüche

1. Gasbarrierefilmlaminat, welches mindestens zwei Gasbarrierefilme und eine Verbindungsschicht umfasst, wobei die mindestens zwei Gasbarrierefilme durch die Verbindungsschicht gestapelt werden,
die Verbindungsschicht eine Konfiguration aufweist, bei welcher eine druckempfindliche Klebschicht durchgehend auf jede Seite der Grundfolie A gestapelt ist, die Grundfolie A aus einem Kunstharz gebildet ist, mit einem Zugmodul bei 23°C von 3000 bis 10.000 MPa, gemessen bei 23°C gemäß JIS K 7127.

2. Gasbarrierefilmlaminat nach Anspruch 1, wobei die Grundfolie A eine Dicke von 0,5 bis 25 µm aufweist.

3. ┐. arrierefilmlaminat nach Anspruch 1, wobei die druckempfindliche Klebschicht, die auf jede Seite der Grundfolie A gestapelt ist, eine Dicke von 0,5 bis 25 µm aufweist.

4. Gasbarrierefilmlaminat nach Anspruch 1, wobei die druckempfindliche Klebschicht eine 180°-Abziehhaftfestigkeit in Bezug auf den Gasbarrierefilm, gemessen gemäß JIS Z 0237 (2000), von 2,0 N/25 mm oder mehr aufweist.

5. Gasbarrierefilmlaminat nach Anspruch 1, wobei die Verbindungsschicht eine Dicke von 75 µm oder weniger aufweist.

6. Gasbarrierefilmlaminat nach Anspruch 1, wobei der Gasbarrierefilm, der auf eine Seite der Verbindungsschicht gestapelt ist, eine Dicke aufweist, die geringer ist als die des Gasbarrierefilms, der auf die andere Seite der Verbindungsschicht gestapelt ist.

7. Gasbarrierefilmlaminat nach Anspruch 1, wobei das Verhältnis der Dicke des Gasbarrierefilms, der auf eine Seite der Verbindungsschicht gestapelt ist zur Dicke des Gasbarrierefilms, der auf die andere Seite der Verbindungsschicht gestapelt ist (Dicke des Gasbarrierefilms, auf die eine Seite der Verbindungsschicht gestapelt / Dicke des Gasbarrierefilms, auf die andere Seite der Verbindungsschicht gestapelt) 0,05 bis 1,0 beträgt.

8. Gasbarrierefilmlaminat nach Anspruch 1, wobei mindestens ein Gasbarrierefilm eine Grundfolie B umfasst, und mindestens eine Gasbarriereschicht auf der Grundfolie B bereitgestellt ist.

9. Gasbarrierefilmlaminat nach Anspruch 8, wobei die Gasbarriereschicht eine Schicht ist, die durch Ionen Implantation in eine Schicht, die eine Silizium-basierte Polymerverbindung umfasst, gebildet ist.

10. Gasbarrierefilmlaminat nach Anspruch 8, wobei der Gasbarrierefilm so gestapelt ist, dass die Gasbarriereschicht durchgehend an der Verbindungsschicht liegt.

11. Gasbarrierefilmlaminat nach Anspruch 1, wobei das Gasbarrierefilmlaminat eine Dicke von 100 µm oder weniger aufweist.

12. Elektronisches Vorrichtungselement, welches das Gasbarrierefilmlaminat nach Anspruch 1 umfasst.

13. Elektronische Vorrichtung, die das elektronische Vorrichtungselement nach Anspruch 12 umfasst.

## Revendications

1. Stratifié à film barrière aux gaz comprenant au moins deux films barrières aux gaz et une couche de liaison, les au moins deux films barrières aux gaz étant superposés par le biais de la couche de liaison,
la couche de liaison ayant une configuration dans laquelle une couche adhésive sensible à la pression est superposée de façon contiguë à chaque face d'un film de base A, le film de base A étant formé d'une résine synthétique ayant un module d'élasticité en traction à 23°C de 3000 à 10 000 MPa, mesuré à 23°C selon la norme JIS K 7127.

2. Stratifié à film barrière aux gaz selon la revendication 1, dans lequel le film de base A a une épaisseur de 0,5 à 25 µm.

3. Stratifié à film barrière aux gaz selon la revendication 1, dans lequel la couche adhésive sensible à la pression superposée à chaque face du film de base A a une épaisseur de 0,5 à 25 µm.

4. Stratifié à film barrière aux gaz selon la revendication 1, dans lequel la couche adhésive sensible à la pression a une résistance au pelage à 180° par rapport au film barrière aux gaz, mesurée selon la norme JIS Z 0237 (2000), de 2,0 N/25 mm ou plus.

5. Stratifié à film barrière aux gaz selon la revendication 1, dans lequel la couche de liaison a une épaisseur inférieure ou égale à 75 µm.

6. Stratifié à film barrière aux gaz selon la revendication 1, dans lequel le film barrière aux gaz superposé à une face de la couche de liaison a une épaisseur inférieure à celle du film barrière aux gaz superposé à l'autre face de la couche de liaison.

7. Stratifié à film barrière aux gaz selon la revendication 1, dans lequel le rapport entre l'épaisseur du film barrière aux gaz superposé à une face de la couche de liaison et l'épaisseur du film barrière aux gaz superposé à l'autre face de la couche de liaison (épaisseur du film barrière aux gaz superposé à une face de la couche de liaison/épaisseur du film barrière aux gaz superposé à l'autre face de la couche de liaison) est de 0,05 à 1,0.

8. Stratifié à film barrière aux gaz selon la revendication 1, dans lequel au moins un film barrière aux gaz inclut un film de base B, et au moins une couche barrière aux gaz prévue sur le film de base B.

9. Stratifié à film barrière aux gaz selon la revendication 8, dans lequel la couche barrière aux gaz est une couche formée en implantant des ions dans une couche qui inclut un composé polymère à base de silicium.

10. Stratifié à film barrière aux gaz selon la revendication 8, dans lequel le film barrière aux gaz est superposé de telle sorte que la couche barrière aux gaz soit contiguë à la couche de liaison.

11. Stratifié à film barrière aux gaz selon la revendication 1, le stratifié à film barrière aux gaz ayant une épaisseur inférieure ou égale à 100 µm.

12. Elément de dispositif électronique comprenant le stratifié à film barrière aux gaz selon la revendication 1.

13. Dispositif électronique comprenant l'élément de dispositif électronique selon la revendication 12.
